# EUROPEAN PATENT APPLICATION

(11) **EP 2 584 642 A1**
(43) Date of publication of application: **24.04.2013**
(21) Application number: 12178456.5
(22) Date of filing: 30.07.2012
(51) Int. Cl.: H01M 10/42, H01L 23/31, H05K 1/00

(54) **Protective circuit module and battery pack having the same**

(30) Priority: 20.10.2011 US 201161549445 P; 20.07.2012 US 201213554811
(71) Applicant: Samsung SDI Co., Ltd., Gyeonggi-do (KR)
(72) Inventor: Byun, Bohyun, Gyeonggi-do (KR)
(74) Representative: Mounteney, Simon James

(57) **Abstract**

A protective circuit module for controlling an electrical state of a secondary battery, the said protective circuit module comprising: a printed circuit board; an integrated circuit chip mounted on the printed circuit board; a passive device electrically connected to the integrated circuit chip; and an encapsulant; wherein the encapsulant encapsulates the integrated circuit chip and a first part of the passive device, but does not encapsulate a second part of the passive device.

## Description

The present invention relates to a protective circuit module and a battery pack having the same.

### BACKGROUND

In general, a lithium-based secondary battery such as a lithium ion secondary battery or lithium polymer secondary battery has a higher energy density per unit weight and a smaller mass than a typical lead storage battery, a nickel/cadmium (Ni-Cd) battery, or a nickel/hydrogen (Ni-MH) battery. Such a battery is often used as a power source in a portable electronic device such as a smart phone, cellular phone, notebook computer, or electronic tool.

However, since such a lithium-based secondary battery has an unstable chemical composition, it may be highly susceptible to damage in the event of an abnormal operation, such as puncture, compression, external short, over-charge, over-discharge, over-current, heating, drop, cutting, etc. Thus, in order to protect the secondary battery from over-charge, over-discharge, or over-current or to prevent the secondary battery from deteriorating in performance, a battery pack is typically manufactured by installing a protective circuit module on the secondary battery.

The present invention sets out to provide a protective circuit module that can simplified mounting of components and a reduction of component mounting costs whilst having a reduced overall size. The invention also seeks to provide a battery pack having the same.

The invention further seeks to provide a protective circuit module and battery pack in which strength is enhanced and operational failure may be easily detected.

Accordingly, a first aspect of the invention provides a protective circuit module as set out in Claim 1. Preferred features of this aspect of the invention are set out in Claims 2 to 12. A further aspect of the invention provides a battery pack as set out in Claim 13. Preferred features of this aspect of the invention are set out in Claims 14 and 15.

In embodiments of the present invention, since a portion of the passive device is coupled to the encapsulant, the strength of the passive device against an external impact can be enhanced.

Further since a second part of the passive device is exposed to the outside of the encapsulant, an electrical failure of the passive device, if any, can be easily determined.

### BRIEF DESCRIPTION OF THE DRAWINGS

Embodiments of the invention will be described hereinafter by reference to the accompanying drawings, in which:-
FIG. 1 is a circuit diagram illustrating an exemplary protective circuit module;
FIGS. 2A and 2B are a plan view and a bottom view of a protective circuit module according to an embodiment of the present invention, and FIG. 2C is a plan view of a printed circuit board before an electronic device is mounted thereon;
FIGS. 3A and 3B are a plan view and a bottom view of an electronic device in the protective circuit module according to an embodiment of the present invention;
FIGS. 4A and 4B are cross-sectional views taken along lines 4a-4a and 4b-4b of FIG. 3A;
FIGS. 5A, 5B and 5C are cross-sectional views taken along lines 5a-5a, 5b-5b and 5c-5c of FIG. 2A;
FIG. 6 is an exploded view of an example of a battery pack having a protective circuit module according to the present invention; and
FIG. 7 is an exploded view of another example of a battery pack having a protective circuit module according to the present invention.

Throughout the specification, it will be understood that when an element or layer is referred to as being "on" or "connected to" another element or layer, it can be directly on or connected to the other element or layer or intervening elements or layers may be present.

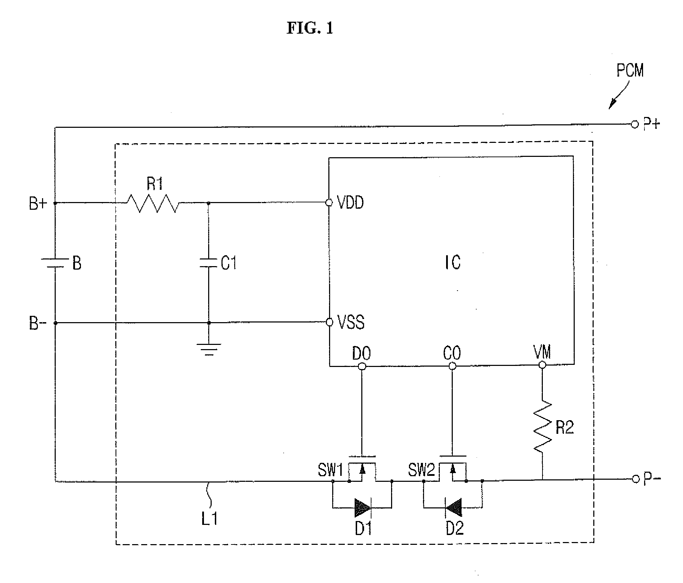

Referring to FIG.1, a protective circuit module (PCM) includes an integrated circuit (IC) chip, a discharge control switch (SW1), a charge control switch (SW2), a first resistor (R1), a second resistor (R2) and a capacitor (C1).

The IC chip is electrically connected to a secondary battery (B) to detect the voltage and current of the secondary battery B, and controls the discharge control switch SWI or the charge control switch SW2 to prevent the secondary battery B from being over-discharged or over-charged. In addition, the IC chip serves to prevent over-current from flowing through the secondary battery B.

The discharge control switch SWI is electrically connected between a charge/discharge line (L1) and the IC chip and is turned off by a control signal of the IC chip when a voltage of the secondary battery B drops to a predetermined voltage level. Even when over-current flows from the secondary battery B during discharging, the discharge control switch SWI is turned off. In addition, since a body diode D1 and the discharge control switch SWI are connected in parallel, even if the discharge control switch SWI is turned off, the secondary battery B can be charged.

The charge control switch SW2 is electrically connected between the charge/discharge line L1 and the IC chip and is turned off by the control signal of the IC chip when a voltage of the secondary battery B exceeds a predetermined voltage level. Even when over-current is supplied to the secondary battery B during charging, the charge control switch SW2 is turned off. In addition, since a body diode D2 and the charge control switch SW2 are connected in parallel, even if the charge control switch SW2 is turned off, the secondary battery B can be discharged.

The first resistor R1 is electrically connected between the secondary battery B and the IC chip, by which the IC chip can be protected from externally induced static electricity and the power supplied to the IC chip can be maintained at a constant level.

The second resistor R2 is electrically connected between the charge/discharge line L1 and the IC chip, by which a value of current flowing in the charge/discharge line L1 can be sensed to allow the IC chip to properly control a protection operation. When an electric short occurs between positive and negative electrode pack terminals P+ and P- of the protective circuit module PCM, the electric short is detected by the second resistor R2 to then be transmitted to the IC chip. Then, the IC chip turns off the discharge control switch SW1, thereby shutting down the flow of high current due to external short.

The capacitor Cl is electrically connected between the first resistor R1 and the secondary battery B, by which a variation in the power supplied to the IC chip may be suppressed.

Undefined reference symbols VDD, VSS, DO, CO, and VM denote a power supply terminal, a ground terminal, a gate connection terminal of the discharge control switch SWl, a gate connection terminal of the charge control switch SW2, and a connection terminal of the second resistor R2, respectively.

Meanwhile, the IC chip, the discharge control switch SWl, the charge control switch SW, the first resistor R1, the second resistor R2 and the capacitor Cl may be defined as individual electronic devices. In addition, the first resistor R1, the second resistor R2 and the capacitor Cl may be defined as passive devices. The electronic devices may be mounted on the printed circuit board to then be electrically connected to each other.

In addition, as will later be described in detail, the IC chip, the discharge control switch SWl, the charge control switch SW2, the first resistor R1, the second resistor R2 and the capacitor C1 are encapsulated by the encapsulant of the encapsulating portion, and terminals respectively provided in the first resistor R1, the second resistor R2 and the capacitor Cl are exposed or protrude to the outside of the encapsulating portion.

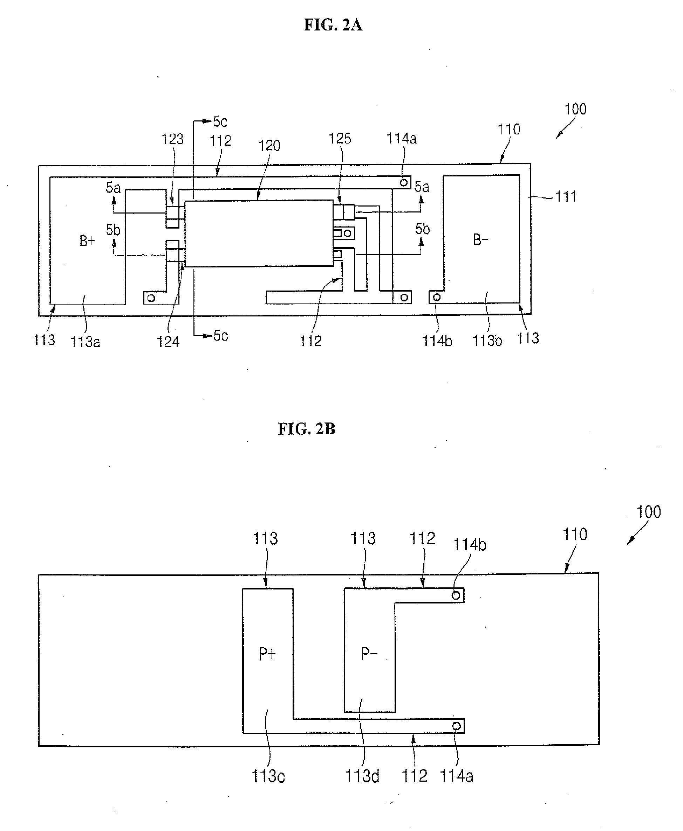

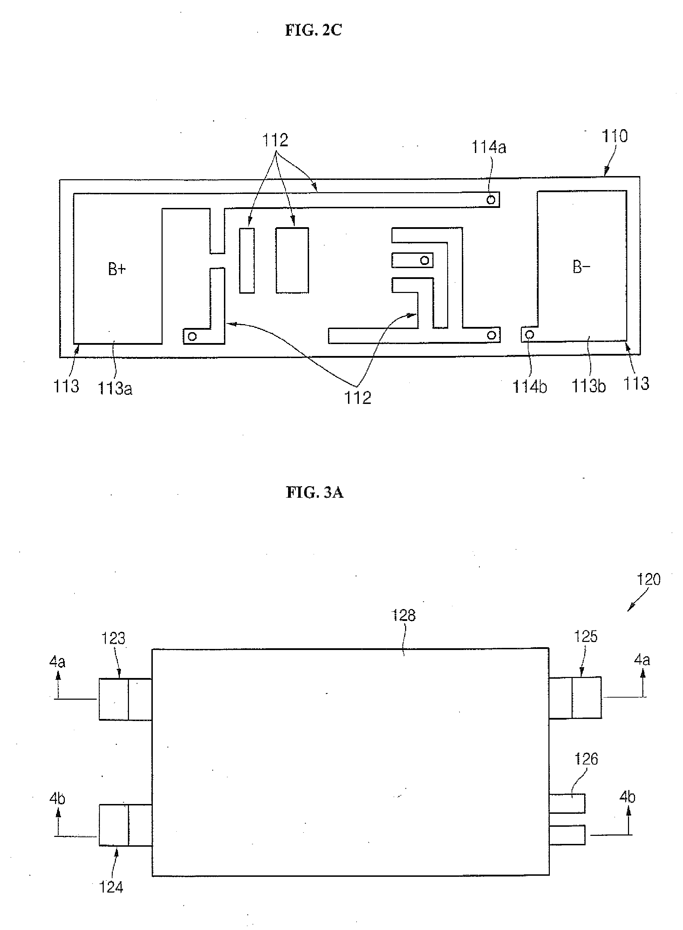

FIGS. 2A and 2B are a plan view and a bottom view of a protective circuit module according to an embodiment of the present invention, and FIG. 2C is a plan view of a printed circuit board before an electronic device is mounted thereon.

As shown in FIGS. 2A to 2C, the protective circuit module 100 according to an embodiment of the present invention includes a printed circuit board 110 and an electronic device 120 mounted on the printed circuit board 110.

The printed circuit board 110 includes an insulating layer 111, and a plurality of wiring patterns 112 and a plurality of electrode pads 113 formed on the insulating layer 111.

The insulating layer 111 may be formed of one selected from a phenol resin, an epoxy resin, polyimide and equivalents thereof, but aspects of the present invention are not limited thereto.

The wiring patterns 112 are formed on a surface of the insulating layer 111, and may be formed of a material selected from copper and equivalents thereof, but aspects of the present invention are not limited thereto. The wiring patterns 112 may be used as charge/discharge paths through which high current mainly flows, or may be used to electrically connect the respective terminals of the electronic device 120.

The electrode pads 113 include a battery positive electrode pad 113a and a battery negative electrode pad 113b, which are formed on one surface of the insulating layer 111, and a pack positive electrode pad 113c and a pack negative electrode pad 113d, which are formed on the other surface of the insulating layer 111. The electrode pads 113 are electrically connected to the wiring patterns 112. The positive electrode terminal B+ of the secondary battery B is electrically connected to the battery positive electrode pad 113a, and the negative electrode terminal B- of the secondary battery B is electrically connected to the battery negative electrode pad 113b. In addition, the pack positive electrode pad 113c and the pack negative electrode pad 113d are electrically connected to the wiring patterns 112 through conductive vias 114a and 114b passing through the insulating layer 111.

The electronic device 120 is electrically connected to the wiring patterns 112. As described above, the electronic device 120 includes an IC chip, a discharge control switch, a charge control switch and a plurality of passive devices. The passive devices include a first resistor 123, a capacitor 124 and a second resistor 125.

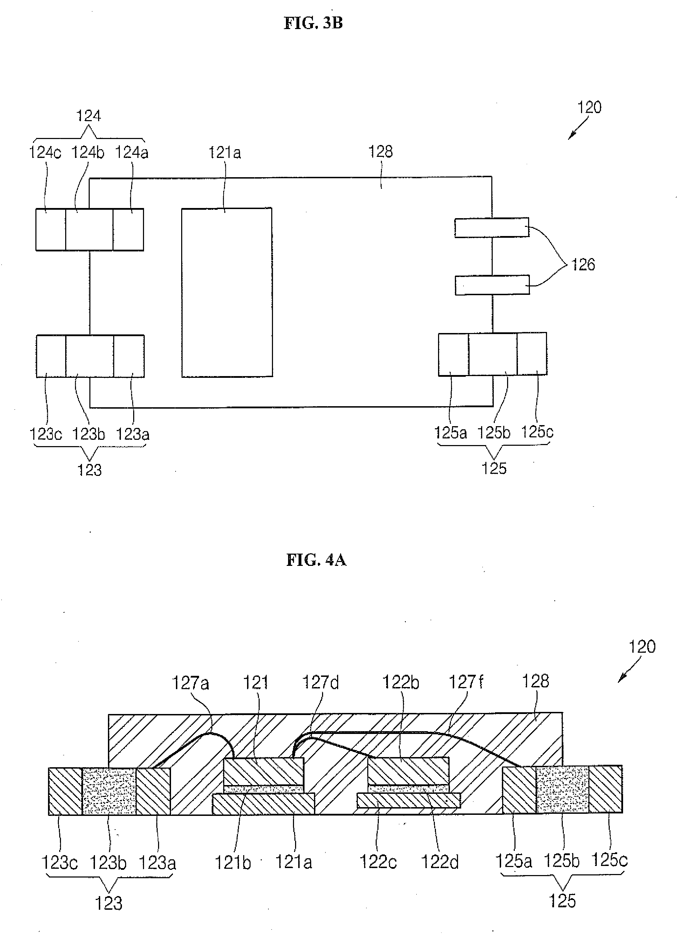

FIGS. 3A and 3B are a plan view and a bottom view of an electronic device in the protective circuit module according to an embodiment of the present invention.

As shown in FIGS. 3A and 3B, the electronic device 120 is usually wrapped with an encapsulating portion 128 formed from an encapsulant. The encapsulant may include an epoxy molding compound (EMC) and equivalents thereof, but aspects of the present invention are not limited thereto.

The passive devices, including the first resistor 123, the capacitor 124 and the second resistor 125, are partially exposed or protrude to the outside through the encapsulating portion 128. In addition, a plurality of lead terminals 126 are also exposed or protrude to the outside through the encapsulating portion 128.

Here, the respective passive devices include first terminals 123a, 124a and 125a, device units 123b, 124b and 125b, and second terminals 123c, 124c and 125c. Portions of the first terminals 123a, 124a and 125a and portions of the device units 123b, 124b and 125b are encapsulated by the encapsulating portion 128, and portions of the second terminals 123c, 124c and 125c and other portions of the device units 123b, 124b and 125b are not encapsulated by the encapsulating portion 128. In addition, since bottom surfaces of the first terminals 123a, 124a and 125a and the device units 123b, 124b and 125b are coplanar with a bottom surface of the encapsulating portion 128, the bottom surfaces of the first terminals 123a, 124a and 125a and the device units 123b, 124b and 125b are exposed to the outside. Moreover, since a bottom surface of a chip mounting board 121 a having an IC chip 121 mounted thereon is coplanar with the bottom surface of the encapsulating portion 128, the bottom surface of the chip mounting board 121 a is also exposed to the outside through the encapsulating portion 128.

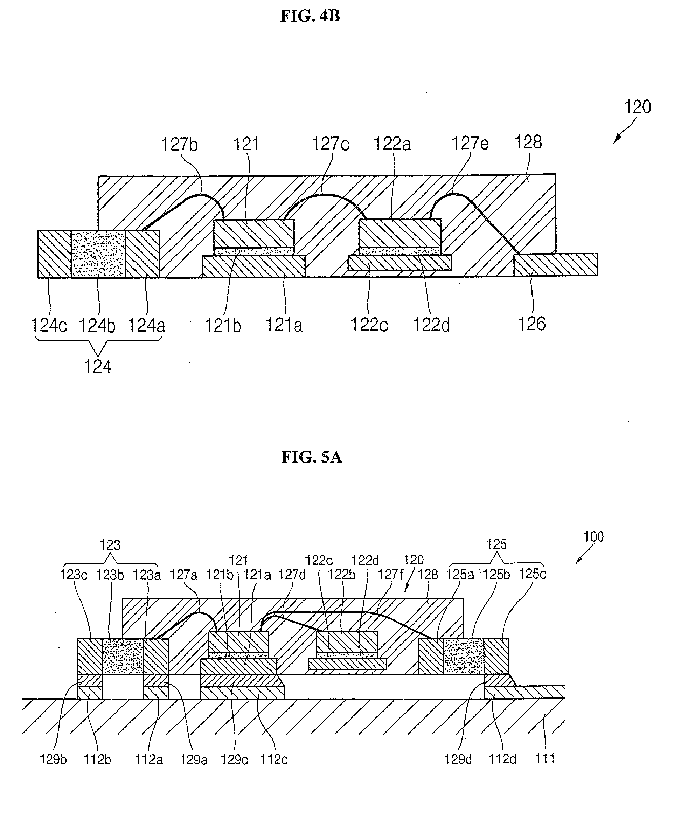

FIGS. 4A and 4B are cross-sectional views taken along lines 4a-4a and 4b-4b of FIG. 3A.

As shown in FIGS. 4A and 4B, the electronic device 120 includes the IC chip 121, the chip mounting board 121a on which the IC chip 121 is mounted, a discharge control switch 122a, a charge control switch 122b, a switch mounting board 122c on which the discharge and charge control switches 122a and 122b are mounted, a first resistor 123 and a capacitor 124 positioned at one side of the integrated circuit chip 121, a second resistor 125 positioned at one side of the charge control switch 122b, lead terminals 126 positioned at one side of the discharge control switch 122a, a plurality of conductive wires 127a, 127b, 127c, 127d, 127e and 127f, and an encapsulating portion 128 that encapsulates the above-stated components.

Here, the conductive wire 127a electrically connects the integrated circuit chip 121 to the first resistor 123, the conductive wire 127b electrically connects the integrated circuit chip 121 to the capacitor 124, the conductive wire 127c electrically connects the integrated circuit chip 121 to the discharge control switch 122a, the conductive wire 127d electrically connects the integrated circuit chip 121 to the charge control switch 122b, the conductive wire 127e electrically connects the discharge control switch 122a to the lead terminal 126, and the conductive wire 127f electrically connects the integrated circuit chip 121 to the second resistor 125.

The passive devices including the first resistor 123, the capacitor 124 and the second resistor 125 will now be described in more detail.

The first resistor 123 includes the first terminal 123a, the device unit 123b and the second terminal 123c. Portions of the first terminal 123a and the device unit 123b are positioned inside the encapsulating portion 128, and the other portions of the device unit 123b and the second terminal 123c are exposed and protrude to the outside of the encapsulating portion 128. Here, the bottom surfaces of the first terminal 123a, the device unit 123b and the second terminal 123c are coplanar with the bottom surface of the encapsulating portion 128. Therefore, the bottom surfaces of the first terminal 123a and the device unit 123b are exposed to the outside of the encapsulating portion 128 through the bottom surface of the encapsulating portion 128. In addition, the first terminal 123b of the first resistor 123 is electrically connected to the IC chip 121 through the conductive wire 127a.

Meanwhile, the capacitor 124 also includes a first terminal 124a, a device unit 124b and a second terminal 124c. Portions of the first terminals 124a and the device unit 124b are positioned inside the encapsulating portion 128, and other portions of the device unit 124b and the second terminal 124c protrude and extend to the outside of the encapsulating portion 128. Here, bottom surfaces of the first terminal 124a, the device unit 124b and the second terminal 124c are coplanar with the bottom surface of the encapsulating portion 128. Therefore, the bottom surfaces of the first terminal 124a and the device unit 124b are exposed to the outside of the encapsulating portion 128 through the bottom surface of the encapsulating portion 128. In addition, the first terminal 124a of the capacitor 124 is electrically connected to the IC chip 121 through the conductive wire 127b.

The second resistor 125 also includes a first terminal 125a, a device unit 125b and a second terminal 125c. Portions of the first terminal 125a and the device unit 125b are positioned inside the encapsulating portion 128, and other portions of the device unit 125b and the second terminal 125c protrude and extend to the outside of the encapsulating portion 128. Here, bottom surfaces of the first terminal 125a, the device unit 125b and the second terminal 125c are coplanar with the bottom surface of the encapsulating portion 128. Therefore, the bottom surfaces of the first terminal 125a and the device unit 125b are exposed to the outside of the encapsulating portion 128 through the bottom surface of the encapsulating portion 128. In addition, the first terminal 125a of the second resistor 125 is electrically connected to the IC chip 121 through the conductive wire 127f.

Meanwhile, a bottom surface of the chip mounting board 121a having the integrated circuit chip 121 mounted thereon is also coplanar with the bottom surface of the encapsulating portion 128. Therefore, the bottom surface of the chip mounting board 121 a is exposed to the outside of the encapsulating portion 128 through the bottom surface of the encapsulating portion 128. Here, even if the chip mounting board 121 a is mounted in wiring patterns 112 provided on the printed circuit board 110, since the IC chip 121 is mounted on the chip mounting board 121a using an insulating adhesive 121b, unwanted electrical shorts between the IC chip 121 and the wiring patterns 112 can be avoided.

However, the switch mounting board 122c on which the discharge control switch 122a and the charge control switch 122b is positioned inside the encapsulating portion 128 and is not exposed to the outside. That is to say, if the switch mounting board 122c is exposed to the outside of the encapsulating portion 128, since the discharge control switch 122a and the charge control switch 122b are mounted on the switch mounting board 122c using a conductive adhesive 122d, unwanted electrical shorts can be avoided.

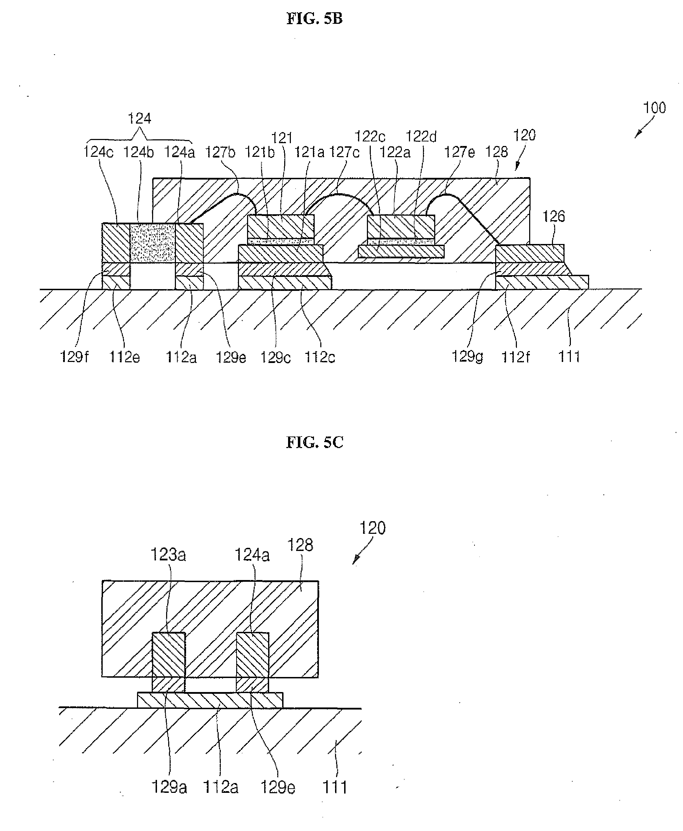

FIGS. 5A, 5B and 5C are cross-sectional views taken along lines 5a-5a, 5b-5b and 5c-5c of FIG. 2A.

First as shown in FIG. 5A, the first terminal 123a of the first resistor 123 positioned inside the encapsulating portion 128 is mounted in the wiring pattern 112a of the printed circuit board 110 provided under the encapsulating portion 128 through a solder 129a. In addition, the second terminal 123c of the first resistor 123 protrudes to the outside of the encapsulating portion 128 is also mounted in the wiring pattern 112b of the printed circuit board 110. Further, the chip mounting board 121a provided under the encapsulating portion 128 is also mounted in the wiring pattern 112c of the printed circuit board 110 through a solder 129c. The second terminal 125c of the second resistor 125 protrudes to the outside of the encapsulating portion 128 is also mounted in the wiring pattern 112d of the printed circuit board 110 through a solder 129d. Here, the first terminal 125a of the second resistor 125 is connected to the IC chip 121 through the conductive wire 127f. However, it is not necessary for the first terminal 125a to be mounted in any wiring pattern of the printed circuit board 110.

As shown in FIG. 5B, the first terminal 124a of the capacitor 124 positioned inside the encapsulating portion 128 is mounted in the wiring pattern 112a of the printed circuit board 110 provided under the encapsulating portion 128 through a solder 129e. Here, the first terminal 124a of the capacitor 124 and the first terminal 123a of the first resistor 123 are electrically connected to each other through the wiring pattern 112a. Further, the lead terminal 126 is also mounted in the wiring pattern 112f of the printed circuit board 110 through a solder 129g.

As shown in FIG. 5C, the first terminal 123a of the first resistor 123 and the first terminal 124a of the capacitor 124, positioned inside the encapsulating portion 128, are mounted in the wiring pattern 112a of the printed circuit board 110 through solders 129a and 129e. Therefore, the first resistor 123 and the capacitor 124 are electrically connected to each other, as shown in FIG. 1.

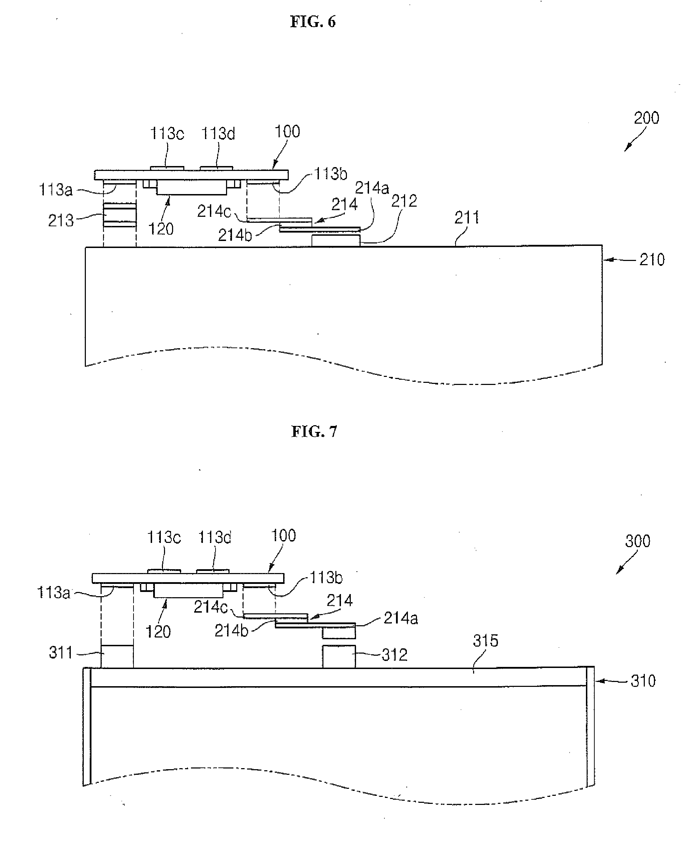

FIG. 6 is an exploded view of an example of a battery pack having a protective circuit module according to the present invention.

As shown in FIG. 6, the protective circuit module 100 is electrically connected to a prismatic battery cell 210, thereby implementing a prismatic battery pack 200. Here, the protective circuit module 100 includes passive devices provided in one electronic device 120, including an IC chip, a discharge control switch, a charge control switch, a first resistor, a second resistor, and a capacitor, so that it can be implemented with a considerably smaller size than the conventional protective circuit module. In this embodiment, the protective circuit module 100 can be manufactured to have a width of half to two thirds that of the prismatic battery cell 210.

In addition, in the prismatic battery cell 210, since a case 211 itself has, for example, a positive polarity, the case 211 and the battery positive electrode pad 113a of the protective circuit module 100 may be connected to each other with a conductive connector 213 interposed therebetween. Further, a negative electrode terminal 212 of the prismatic battery cell 210 and a battery negative electrode pad 113b of the protective circuit module 100 may be connected to each other with a PTC assembly 214 interposed therebetween. Here, the PTC assembly 214 includes a first lead plate 214a connected to the negative electrode terminal 212, a PTC device 214b connected to the first lead plate 214a, and a second lead plate 214c connected to the PTC device 214b and the battery negative electrode pad 113b.

Of course, a resin (not shown) may be interposed between the protective circuit module 100 and the prismatic battery cell 210, and the resin may wrap regions of the protective circuit module 100 other than a pack positive electrode pad 113c and a pack negative electrode pad 113d.

FIG. 7 is an exploded view of another example of a battery pack having a protective circuit module according to the present invention.

As shown in FIG. 7, the protective circuit module 100 is electrically connected to a pouch-type battery cell 310, thereby implementing a pouch-type battery pack 300. As described above, the protective circuit module 100 can be manufactured to have a width of half to two thirds that of the pouch-type battery cell 310.

In addition, a positive electrode cell tab 311 of the pouch-type battery cell 310 and a battery positive electrode pad 113a of the protective circuit module 100 may be connected to each other. Further, a negative electrode cell tab 312 of the pouch-type battery cell 310 and a battery negative electrode pad 113b of the protective circuit module 100 may be connected to each other with a PTC assembly 214 interposed therebetween. Here, the PTC assembly 214 includes a first lead plate 214a connected to the negative electrode cell tab 312, a PTC device 214b connected to the first lead plate 214a, and a second lead plate 214c connected to the PTC device 214b and the battery negative electrode pad 113b.

Alternatively, the positive electrode cell tab 311 and the negative electrode cell tab 312 may be bent, and the protective circuit module 100 may be seated on a terrace portion 315 provided in the pouch-type battery cell 310.

Embodiments of a protective circuit module and a battery pack having the same have been disclosed herein, and although specific terms are employed, they are used and are to be interpreted in a generic and descriptive sense only and not for purpose of limitation. Accordingly, it will be understood by those of ordinary skill in the art that various changes in form and details may be made without departing from the scope of the present invention as set forth in the following claims.

## Claims

1. A protective circuit module (100) for controlling an electrical state of a secondary battery, the said protective circuit module (100) comprising:
a printed circuit board (110);
an integrated circuit chip (121) mounted on the printed circuit board (110);
a passive device (123, 125, 124) electrically connected to the integrated circuit chip (121); and
an encapsulant (128);
wherein the encapsulant (128) encapsulates the integrated circuit chip (121) and a first part of the passive device (123, 125, 124), but does not encapsulate a second part of the passive device (123, 125, 124).

2. A protective circuit module according to claim 1, comprising a plurality of passive devices (123, 125, 124), each of which is electrically connected to the integrated circuit chip (121); wherein the encapsulant (128) encapsulates a respective first part of each said passive device (123, 125, 124), but does not encapsulate a respective second part of each said passive device (123, 125, 124).

3. A protective circuit module according to claim 1 or 2, wherein at least one said passive device (123, 125, 124) comprises a first terminal (123a, 124a, 125a), a body (123b, 124b, 125b) and a second terminal (123c, 124c, 125c); wherein the said first part of the passive device (123, 125, 124) comprises the first terminal (123a, 124a, 125a) and a first portion of the body (123b, 124b, 125b) and the said second part of the passive device (123, 125, 124) comprises the second terminal (123c, 124c, 125c) and a second portion of the body (123b, 124b, 125b).

4. A protective circuit module according to claim 3, wherein the or each first terminal (123a, 124a, 125a) has a surface thereof exposed to the outside of the encapsulant (128).

5. A protective circuit module according to claim 3 or 4, wherein the or each said first portion of the body (123b, 124b, 125b) has a surface thereof exposed to the outside of the encapsulant (128).

6. A protective circuit module according to claim 3, 4 or 5, wherein the or each first terminal (123a, 124a, 125a) is connected to the integrated circuit chip (110) via a conductive wire (127a, b, f).

7. A protective circuit module according to one of claims 3 to 5, wherein the or each said first terminal (123a, 124a, 125a) is mounted on the printed circuit board (110).

8. A protective circuit module according to claim 7, wherein the or each said first terminal is electrically connected to the said printed circuit board via a wiring pattern located between the encapsulant and a surface of the printed circuit board.

9. A protective circuit module according to one of claims 3 to 8, wherein the or each said second terminal (123c, 124c, 125c) is mounted on the printed circuit board (110).

10. A protective circuit module according to claim 9, wherein the or each said second terminal is electrically connected to the said printed circuit board via a wiring pattern located on a surface portion of the printed circuitboard that is not overlapped by the encapsulant.

11. A protective circuit module according to any preceding claim, wherein the or each said passive device (123, 125, 124) is a resistor or a capacitor.

12. A protective circuit module according to any preceding claim, wherein the encapsulant encapsulating the said integrated circuit chip is integral with the encapsulant encapsulating the or each passive device.

13. A battery comprising:
a housing (210,310);
an electrode assembly situated within the housing (210, 310); and
a protective circuit module (100);
wherein the protective circuit module (100) is as set out in one of claims 1 to 12.

14. A battery according to claim 13, wherein the battery comprises first and second electrode terminals separated by a first distance extending in a first direction and the length of the protective circuit module in the said first direction is less than the said first distance.

15. A battery according to claim 14, further comprising a temperature-sensitive safety device, the said safety device being connected between an end portion of the said protective circuit module and one of the said electrode terminals.
